# DEMANDE DE BREVET EUROPEEN

(11) **EP 0 718 633 A1**
(43) Date de publication de la demande: **26.06.1996**
(21) Numéro de dépôt: 95440073.5
(22) Date de dépôt: 27.10.1995
(51) Int. Cl.: G01R 11/02

(54) **Dispositif de mesure du courant**

(30) Priorité: 19.12.1994 FR 9415443
(71) Demandeur: ZELLWEGER SAUTER-Energie S.A., F-68200 Mulhouse (FR)
(72) Inventeur: Freyheit, Bernard, F-68110 Illzach (FR)

(57) **Abrégé**

La présente invention concerne un dispositif de mesure du courant pour courants alternatifs du type comportant des moyens de raccordement en série avec une charge et des moyens de prélèvement d'une différence de potentiel représentative de la chute ohmique de tension, caractérisé en ce qu'il comporte un tronçon médian (1), deux éléments de raccordement (10, 14) disposés de part et d'autre dudit tronçon médian (1) et maintenus en place par une bride de fixation (20), et une lame de déconnexion du circuit de tension (22) qui coulisse dans l'élément de raccordement (10).

Partant de contraintes d'encombrement, de précision, de fiabilité de la mesure, de coût, l'objectif de l'invention est de définir une géométrie et des matériaux pour implanter le dispositif de mesure du courant aussi bien dans des compteurs monophasés que triphasés, et selon des spécifications françaises ou internationales.
Par ailleurs, l'objectif de l'invention est d'avoir un système de déconnexion du circuit tension qui fasse appel à une seule pièce et soit facile à utiliser.

## Description

La présente invention concerne un dispositif de mesure du courant. Elle trouve son application dans les compteurs électroniques d'énergie électrique monophasés et triphasés.

On connaît de nombreux dispositifs de mesure du courant constitués d'un élément résistif associé de manière générale à des moyens de raccordement constitués par des pièces simples et qui utilisent comme système de fixation soit un trou soit un pliage ajouté à la pièce de raccordement. L'industrialisation de ces produits demande des moyens de mise en oeuvre sophistiqués pour une géométrie finale qui n'est adaptée qu'à un appareil de comptage monophasé. Certains de ces dispositifs de mesure du courant présentent des angles de pliage à 90° qui augmentent l'échauffement et modifient l'homogénéité du courant.

Le choix d'un matériau pour un élément résistif (shunt) dépend de considérations électriques. Le shunt est une résistance de puissance employée pour mesurer un courant de forte intensité. Le passage de ce courant à travers le shunt crée une chute de tension entre ses bornes. Cette différence de potentiel est généralement considérée comme étant une image fidèle du courant à mesurer. Mais cette vision masque les problèmes de densité locale de courant, de stabilité thermique, de vieillissement, ...

Ainsi, il faut considérer le shunt non plus comme un élément unique mais comme un ensemble d'éléments : élément résistif, soudure, connexions. L'élément résistif étant lui-même considéré comme la mise en série d'une résistance parfaite, d'une résistance dépendant de la température et d'une inductance dépendant de la longueur du barreau et créant un déphasage qui augmente avec la fréquence.

Pour définir la géométrie de l'ensemble il faut connaître la densité locale de courant en chaque point. Ces observations permettent de réduire la taille et linéariser la mesure. En fait, un milieu conducteur est rarement homogène ; on note une discontinuité lors de l'interfaçage entre deux matériaux différents et lors de pliage de matière.

Pour la mesure du courant, les systèmes actuels utilisent principalement le manganin qui a une excellente précision jusqu'à une température du matériau dans l'air de 60 °C. Au-delà, la précision se dégrade. Son utilisation est déconseillée au-delà de 140 °C. De plus, il doit subir un vieillissement accéléré pour garantir une bonne tenue dans le temps. Le manganin est surtout utilisé dans le cas de mesures de courants continus car il n'est pas sensible à l'effet Peltier.

Les systèmes de déconnexion du circuit de tension actuels utilisent principalement des bornes et/ou des vis avec un fil de mesure supplémentaire. Bien que ces systèmes fassent appel à des pièces d'usage courant, ils sont complexes dans leur mise en oeuvre et nécessitent l'utilisation d'outils particuliers pour effectuer les opérations de contrôle.

Partant de contraintes d'encombrement, de précision, de fiabilité de la mesure, de coût, l'objectif de l'invention est de définir une géométrie et des matériaux pour implanter le dispositif de mesure du courant aussi bien dans des compteurs monophasés que triphasés, et selon des spécifications françaises ou internationales (exemple : DIN).
Par ailleurs, l'objectif de l'invention est d'avoir un système de déconnexion du circuit tension qui fasse appel à une seule pièce et soit facile à utiliser.
La figure 1 montre une vue éclatée d'un élément de mesure du courant
La figure 2 montre une vue d'un élément de mesure du courant assemblé
La figure 3 montre une vue de l'ensemble élément de mesure du courant et bride de fixation dans le cas d'un compteur triphasé
La figure 4 montre une vue de la bride de fixation
La figure 5 montre le système de déconnexion du circuit tension en position contact
La figure 6 montre le système de déconnexion du circuit tension en position absence de contact

La présente invention concerne un élément de mesure du courant et son système de déconnexion du circuit tension.

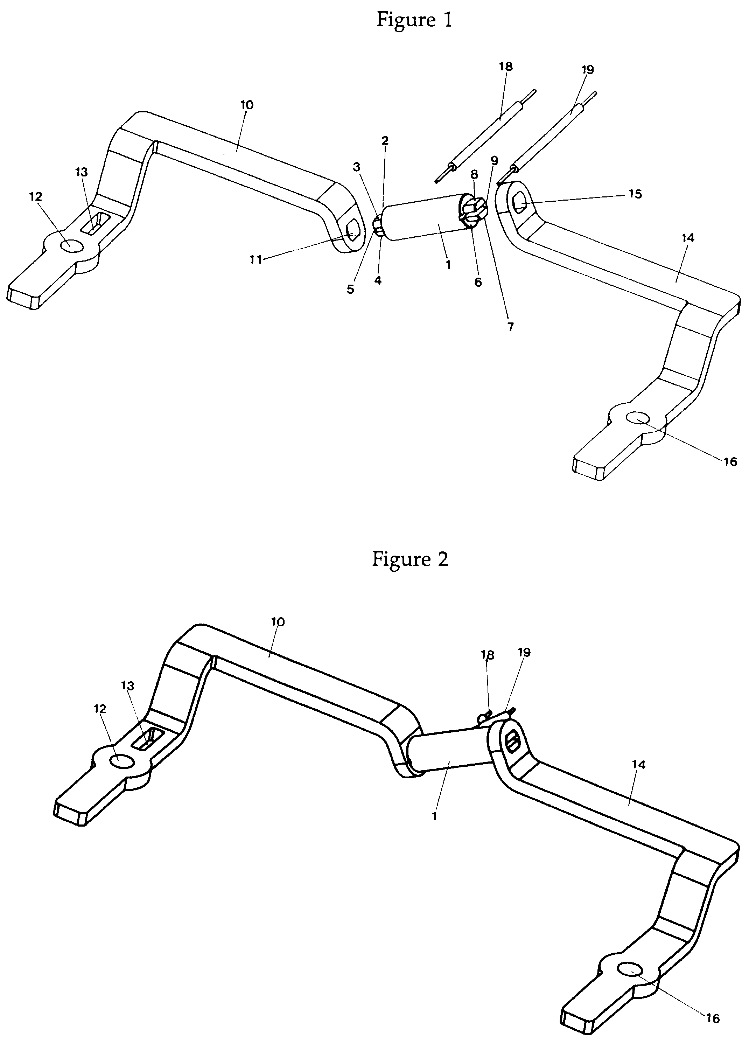

L'élément de mesure du courant représenté en figures 1, 2 et 3 se compose d'un élément résistif 1, de deux éléments de raccordement 10, 14, de deux fils de mesure 18, 19. Cet élément est maintenu par une bride de fixation 20.

Le matériau utilisé pour l'élément résistif 1 est un alliage normalisé CuNi44 (44 % de nickel, 1 % de manganèse, le reste de cuivre) appelé constantan (ou isotan) et choisi pour ses caractéristiques thermiques.

Le constantan a une excellente tenue thermique, ce qui permet de réduire la géométrie de l'ensemble et d'avoir un élément suffisamment petit pour être facilement réalisable et ne pas apporter d'échauffement trop important.

| | Constantan | Manganin |
|---|---|---|
| Température max dans l'air (°C) | 600 | 140 |
| Dilatation (ppm/K) | 13,5 | 18 |
| Tension thermoélectrique à 20°C (µV/K) | -40 | -0,6 |
| Tenue thermique | élevée | faible |
| Résistance aux attaques chimiques | élevée | moyenne |

Le fait d'opter pour une forme de barreau cylindrique pour l'élément résistif 1 améliore la tolérance et facilite l'approvisionnement.

Des essais d'échauffement réalisés à température ambiante (25 °C) sur une disposition barreau en constantan et éléments de raccordement en cuivre désoxydé ont montré que l'échauffement par rapport à la température ambiante dans le cas du passage d'un courant de 90 A est de :
- 70 °C pour le constantan
- 52 à 55 °C (pire cas) pour le cuivre

Connaissant la résistivité du manganin, on atteint, dans les conditions identiques avec un barreau en manganin, une température de matériel qui dépasse 60 °C, limite au-delà de laquelle l'emploi du manganin est déconseillé pour les résistances de précision.

Dans le cas de compteurs monophasés, l'intensité maximale du courant à mesurer peut atteindre 135 A. Le choix du constantan se justifie ainsi pleinement si on veut pouvoir utiliser le même élément de mesure pour les compteurs monophasés et triphasés.

Pour les éléments de raccordement 10, 14 on utilise du cuivre pour sa faible résistivité, bonne conductivité thermique, facilité de formage et de soudage, son inaltérabilité à l'air.

Les connexions des éléments de raccordement 10, 14 à l'élément résistif 1 sont effectuées en soudage par induction avec interposition d'une pastille d'argent.

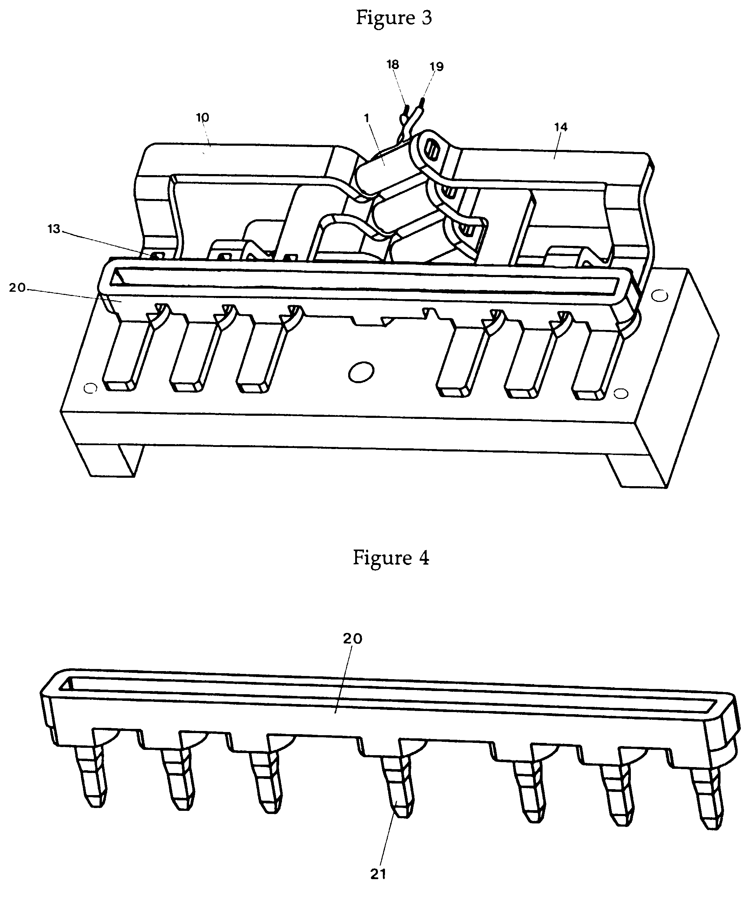

La bride de fixation 20 représentée en figure 4 est en polycarbonate. En effet, outre ses propriétés d'isolation, cette matière présente la particularité de tenir les impératifs de feu et de résistance aux variations de température. Cette bride de fixation 20 est munie de picots 21.

La présente invention représentée en figures 1 et 2 propose un positionnement stable d'un barreau cylindrique de constantan appelé élément résistif 1, entre deux pièces en cuivre désoxydé appelées éléments de raccordement 10, 14.

L'élément résistif 1 est une résistance calibrée à 300 µΩ par exemple, ayant à chacune de ses extrémités un épaulement 2, 6, deux méplats d'orientation 3, 4, 7, 8 et une rainure 5, 9 traversant le barreau diamétralement.

Les picots terminaux de deux fils de mesure 18, 19 sont placés dans les rainures 5, 9. Ces fils sont ensuite torsadés pour empêcher la détection des champs magnétiques perturbateurs.

Les formes des éléments de raccordement 10, 14 sont adoucies, les angles importants sont supérieurs ou égaux à 110° ; le pliage à 90° a été évité, pour réduire l'échauffement et ne pas perturber les lignes de courant. Le courant passe à travers l'élément résistif sur toute sa section. Le passage est frontal, homogène.

Les éléments de raccordement 10, 14 sont munis d'un trou à méplats 11, 15 en regard de l'épaulement 2, 6 et des méplats 3, 4, 7, 8 de l'élément résistif 1, ce qui permet d'insérer le barreau cylindrique dans l'élément de raccordement, facilitant ainsi l'empilage et évitant l'utilisation d'un gabarit de positionnement.

Le trou de fixation 12, 16 des éléments de raccordement 10, 14 permet le passage des picots 21 de la bride de fixation 20 destinée au maintien de l'ensemble. Ce système évite ainsi l'utilisation traditionnelle de vis pour la fixation de l'ensemble élément de mesure sur les borniers de puissance.

Dans le cas d'un compteur triphasé, les trois éléments de mesure du courant sont placés dans un plan coplanaire. Ainsi, en position de fonctionnement, c'est-à-dire lorsque le compteur est accroché verticalement sur son panneau support, les échauffements des trois éléments de mesure sont dissipés individuellement. Il n'y a aucune influence mutuelle. Cette disposition est représentée à la figure 3.

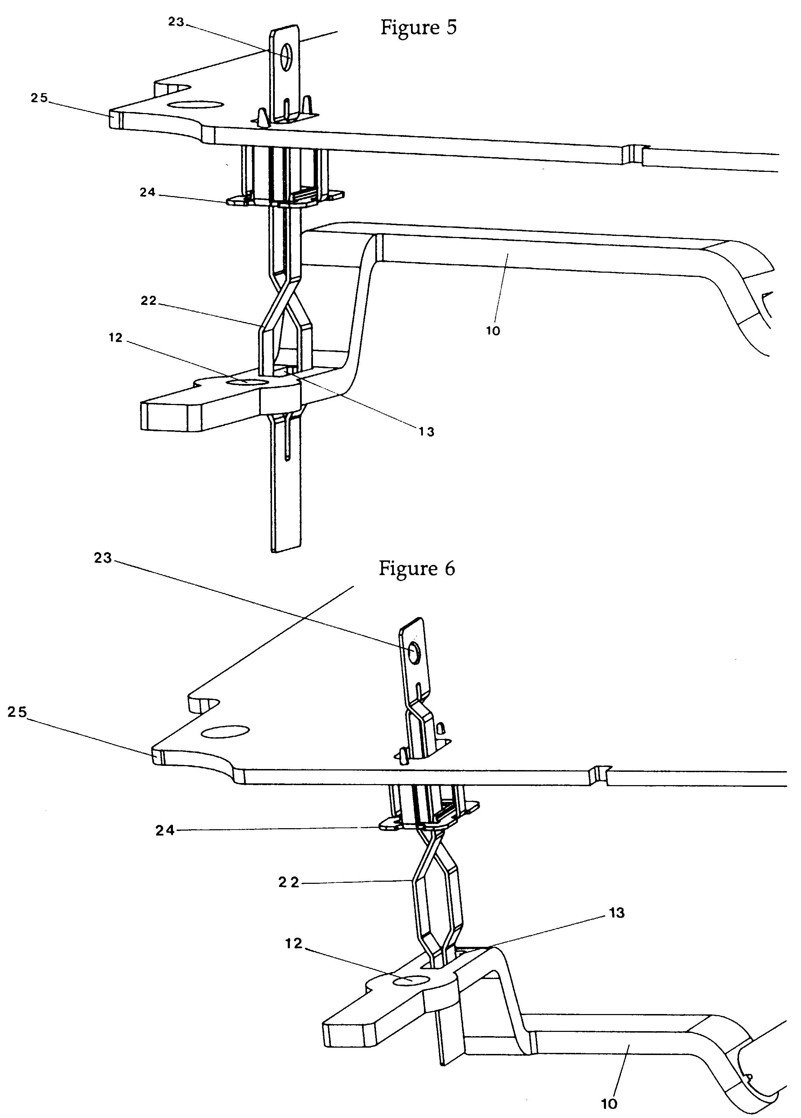

Le dispositif de déconnexion du circuit tension selon l'invention représenté en figures 5 et 6 permet d'effectuer des essais de vérification en puissance fictive sur le bornier de puissance du compteur d'énergie électrique. Il se compose d'une lame à double contact inversé 22 munie d'un évidement 23. Cette lame 22 fait la liaison entre l'élément de raccordement 10 et le circuit imprimé 25 via le trou de déconnexion 13, d'une part, et le frotteur 24, d'autre part. La lame 22 dérive la tension vers le circuit imprimé où un circuit électronique calcule la puissance consommée à partir de cette tension et de l'intensité prélevée sur les fils de mesure 18, 19.

La lame à double contact inversé 22 est en maillechort (alliage cupro-nickel-zinc normalisé CuNi18Zn20, soit 62 % de cuivre, 18 % de nickel et 20 % de zinc, écroui qualité ressort) choisi pour ses qualités de contact, d'inoxydabilité et d'inaltérabilité. Le frotteur 24, également en maillechort, est soudé sur le circuit imprimé 25 et établit la liaison avec ce dernier.

La lame à double contact inversé 22 passe par le trou de déconnexion 13 de l'élément de raccordement 10. La forme de cette lame 22, double contact inversé, constitue la forme de contact idéale, puisque une pression sur l'un des contacts entraîne une pression sur l'autre contact, garantissant ainsi une liaison parfaite entre l'élément de raccordement 10, d'une part, et le frotteur 24, d'autre part.

Deux états sont possibles pour cette lame, l'état "contact" et l'état "pas de contact".

En sortie usine, c'est-à-dire en configuration normale, la lame 22 passe par le trou de déconnexion 13 de l'élément de raccordement 10 où elle établit le contact avec ce dernier ; c'est l'état "contact", qui permet le fonctionnement normal du compteur.

Si un ré-étalonnage du compteur ou un contrôle s'avère nécessaire, il suffit de tirer cette lame 22 vers le haut à l'aide d'un tournevis par exemple, après avoir déposé le cache-borne puissance du compteur ; c'est l'état "pas de contact" car la lame 22 n'est plus en contact avec l'élément de raccordement 10 et ne prélève plus la tension. Il est alors possible d'accrocher une tension régulée d'étalonnage dans l'évidement 23 pour alimenter le circuit électronique et effectuer les opérations de contrôle ou d'étalonnage nécessaires. Ces opérations effectuées, il suffit alors de pousser la lame 22 vers le bas, pour que le contact soit rétabli et que le compteur retourne en position de comptage normal. En cas d'oubli de remise en place de la lame 22, celle-ci sera automatiquement repositionnée dans l'état "contact" lors de la fermeture du cache-bornes puissance.

La lame 22 vient en butée haute contre une découpe dans le cache-borne de puissance et en butée basse contre une nervure dans le socle plastique du compteur. Il est donc impossible de la sortir en tirant trop fort par exemple.

L'élément de mesure du courant selon l'invention :
- est utilisable pour les compteurs électroniques d'énergie électrique monophasés et triphasés selon les spécifications nationales (par exemple EDF)
- est utilisable pour les compteurs électroniques d'énergie électrique selon des spécifications internationales (par exemple DIN) par simple extension de la géométrie
- présente un aspect économique intéressant : facilité de soudage, de montage • est particulièrement fiable et précis

Son dispositif de déconnexion du circuit tension selon l'invention :
- fait intervenir deux pièces simples et peu chères
- garantit une remise en place automatique en position de fonctionnement normal lors de la fermeture du cache-bornes puissance

## Revendications

1. Dispositif de mesure du courant pour courants alternatifs du type comportant des moyens de raccordement en série avec une charge et des moyens de prélèvement d'une différence de potentiel représentative de la chute ohmique de tension, caractérisé en ce qu'il comporte un tronçon médian (1), deux éléments de raccordement (10, 14) disposés de part et d'autre dudit tronçon médian (1) et maintenus en place par une bride de fixation (20), et une lame de déconnexion du circuit de tension (22) qui passe dans l'élément de raccordement (10).

2. Dispositif de mesure du courant selon la revendication 1, caractérisé en ce que le tronçon médian (1) est un barreau cylindrique constitué en un alliage normalisé CuNi44, soit 44 % de nickel, 1 % de manganèse et le reste de cuivre, appelé constantan ou isotan.

3. Dispositif de mesure du courant selon la revendication 2, caractérisé en ce que le tronçon médian comporte à chacune de ses extrémités un épaulement (2, 6) et deux méplats d'orientation (3, 4, 7, 8) destinés à faciliter le centrage et le positionnement du barreau lors du montage dans les élements de raccordement (10, 14) qui comportent un trou à méplats (11, 15).

4. Dispositif de mesure du courant selon la revendication 3, caractérisé en ce que les deux méplats d'orientation (3, 4, 7, 8) du tronçon médian (1) sont munis d'une rainure (5, 9) traversant le barreau diamétralement et destinée à recevoir les picots terminaux des fils de mesure (18, 19).

5. Dispositif de mesure du courant selon la revendication 1, caractérisé en ce que tous les angles des éléments de raccordement (10, 14) sont supérieurs ou égaux à 110°.

6. Dispositif de mesure du courant selon la revendication 5, caractérisé en ce que l'élément de raccordement (10) en cuivre comporte un trou (13) permettant le passage de la lame de déconnexion (22).

7. Dispositif de mesure du courant selon la revendication 1, caractérisé en ce que la bride de fixation (20) en polycarbonate est munie de picots (21) s'insérant dans les trous de fixation (12, 16) des éléments de raccordement (10, 14).

8. Dispositif de mesure du courant selon la revendication 1, caractérisé en ce que la lame de déconnexion (22) qui assure la liaison entre l'élément de raccordement (10) et le circuit imprimé de mesure (25) via un frotteur (24) a une forme de double contact inversé.

9. Dispositif de mesure du courant selon la revendication 8, caractérisé en ce que la lame de déconnexion (22) est en alliage normalisé CuNi18Zn20 écroui qualité ressort, soit 62 % de cuivre, 18 % de nickel et 20 % de zinc, appelé maillechort.
